# EUROPEAN PATENT APPLICATION

(11) **EP 2 302 675 A1**
(43) Date of publication of application: **30.03.2011**
(21) Application number: 09305907.9
(22) Date of filing: 29.09.2009
(51) Int. Cl.: H01L 23/552, H01L 23/64

(54) **Electronic circuit with an inductor**

(71) Applicant: STMicroelectronics (Grenoble 2) SAS, 38000 Grenoble (FR)
(72) Inventor: Coffy, Romain, 38950, SAINT MARTIN LE VINOUX (FR); Imbs, Yvon, 38950 QUAIX EN CHARTEUSE (FR); Marechal, Laurent, 38000, GRENOBLE (FR)
(74) Representative: de Beaumont, Michel

(57) **Abstract**

There is provided an electronic device (1) which comprises an electronic component (10) having a substrate and a plurality of metal interconnection layers (111), the plurality of metal interconnection layers having a top surface. It further comprises a dielectric layer (120) situated above said metal interconnection layers (111), a conductive layer (122) situated above said dielectric layer, an inductor coil (124) and a ground shield (113), the inductor coil (124) being formed in the conductive layer (122) and the ground shield (113) being formed in a layer of said plurality of metal interconnection layers (111).

## Description

### FIELD OF THE INVENTION

The present invention relates to packages for electronic components, particularly but not exclusively to semiconductor components incorporating inductive elements.

### RELEVANT BACKGROUND

Electronic circuits frequently employ inductors and it is useful to place them as close as possible to the actual circuits of which they form part.

It is known to incorporate inductors into the packages of electronic devices. However there is severe price pressure on electronic devices so it is undesirable for such incorporation to increase the costs of the device.

Inductors are, as a consequence of the electromagnetic field they produce, very sensitive to their environment. Thus their incorporation requires care and compromises are necessary. Because of the form of their electromagnetic field, planar inductors are particularly sensitive.

Furthermore, the performance of an inductor is very sensitive to parasitic effects. Both the series resistance of the windings and capacitive coupling, between the inductor and ground and between the windings themselves, reduce the quality factor of the inductor. The quality factor is a measure of the losses incurred in the circuit including the inductor and is therefore of profound influence on overall circuit performance.

These inductors may take the form of discrete surface mount components placed on a printed circuit board substrate (PCB) close to the element having the electronics.

The use of discrete components implies an added cost in terms of component purchase, processing costs and size. Using the PCB metal tracks overcomes the purchase and processing cost issues. However the relatively coarse tolerances of PCB processing mean that the inductor tolerances are quite large.

It is also known to incorporate inductors into semiconductor dice, by using the patterned metal interconnection layers of the alternating patterned metal and insulating layers (commonly known as the 'multilevel interconnect'). Because the windings lie in a plane, rather than being three-dimensional, these are known as planar inductors. Another possibility is to use metal tracks on the PCB to form the windings of the planar inductor.

Planar inductors are often not placed directly facing active components in order to avoid interaction between the electromagnetic field of the inductor and the active component. This is particularly true when the active component is on silicon because the highly doped silicon substrate causes high losses in the inductor.

In the case of PCB planar inductors, they may be placed outside the area of the die. Because the inductor is therefore distanced from the actual circuitry concerned, its overall series resistance is increased, thereby decreasing the inductor quality factor.

The inductors constructed in the semiconductor process benefit from better tolerances but the metal of the multilevel interconnect are limited to a maximum thickness of around 3 µm. This means that the series resistances of the coil windings are high compared to discrete inductors and so their quality factors are correspondingly lower.

Multilayer ceramic packages allow the incorporation of high quality inductors but these are more expensive and generally larger.

It is therefore desirable to provide a means of incorporating higher performance inductors into electronic component packages without increasing the cost and size.

### SUMMARY OF THE INVENTION

Embodiments described herein address this need by providing an electronic device comprising:
- an electronic component having a substrate and a plurality of metal interconnection layers, said plurality of metal interconnection layers having a top surface;
- a dielectric layer situated above said metal interconnection layers;
- at least one conductive layer situated above said dielectric layer;
- an inductor coil and a ground shield,
wherein the inductor coil is formed in at least one of the conductive layers and the ground shield is formed a layer of the plurality of metal interconnection layers.

According to an embodiment of the electronic device, said inductor coil is vertically above said ground coil and the plane of said inductor coil is substantially parallel to the plane of said ground shield.

According to an embodiment of the electronic device, the shortest distance between the inductor coil and said ground shield is not less than 10 µm.

According to an embodiment of the electronic device, the shortest distance between said inductor coil and said ground shield is not greater than 25 µm.

According to an embodiment of the electronic device, the area occupied by said inductor coil is less than that occupied by said ground shield.

According to an embodiment of the electronic device, said electronic component is a semiconductor die.

According to an embodiment of the electronic device, said metal interconnection layers are arranged vertically above one another and said ground shield is formed in a metal interconnection layer close to said substrate.

According to an embodiment of the electronic device, it further comprises a block of molding resin partially encapsulating said electronic component so that said top surface of said metal interconnection layers is left free.

According to an embodiment of the electronic device, the block of molding resin has a top surface flush with said top surface of said metal interconnection layers.

Also provided is an electronic equipment comprising an electronic component according to an embodiment.

There is also provided a process of manufacturing the electronic device according to an embodiment, comprising the steps of:
- providing an electronic component having a plurality of metal interconnection layers in which is formed a ground shield;
- placing a dielectric layer above said multilevel interconnect;
- placing a conductive layer above said dielectric layer;
- forming a pattern in said conductive layer,
wherein the step of patterning the conductive layer forms an inductor coil which is vertically aligned to the ground shield.

According to an embodiment of the process, the dielectric layer and the conductive layer are made using thin-film techniques.

According to an embodiment of the process, it further comprises the step of partially encapsulating the electronic component in molding resin in a way that the top surface of the multilevel interconnect is left free.

According to an embodiment of the process, it further comprises the step of forming a protection layer partially covering said conductive and dielectric layers.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings.
Fig 1 represents a cross-section of an electronic component package according to an embodiment;
Fig 2 represents a plan view the electronic component package of Figure 1;
Fig 3 represents an assembly flow for manufacturing a package like that of Fig 1; and
Fig 4 represents equipment incorporating an electronic component in a package according to an embodiment.

### DETAILED DESCRIPTION OF THE INVENTION

In the interests of clarity, same references designate same elements.

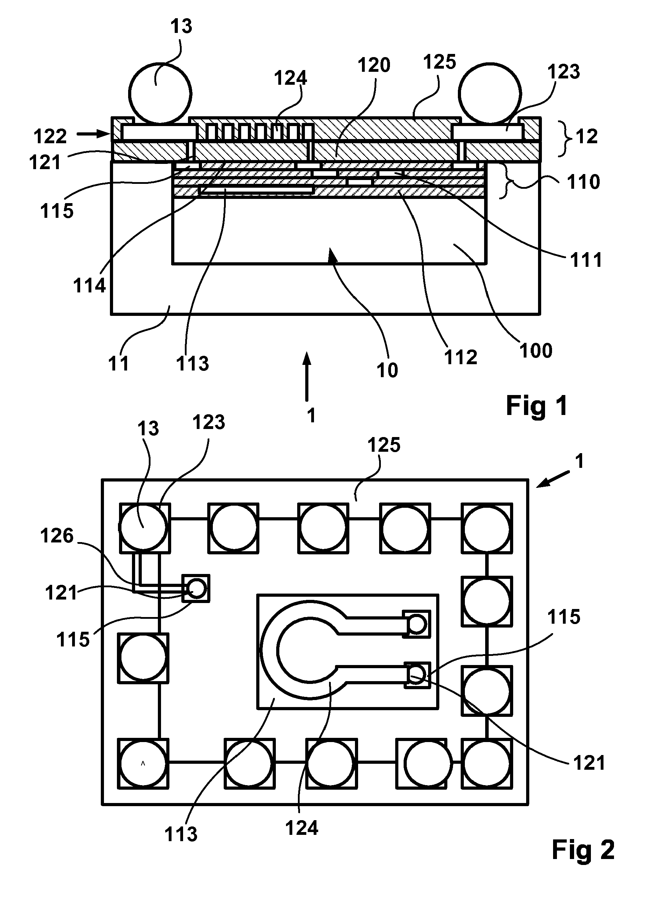

Figure 1 represents a cross-section view of an electronic component 1 according to an embodiment. A semiconductor die 10 is partially enclosed in a block of molding resin 11.

The semiconductor die 10 incorporates active circuitry (not shown) on a substrate 100 and a multilevel interconnect 110, formed of alternating patterned metal layers 111 and insulating layers 112. In one of the metal layers 111, preferably close to the substrate 100, there is an area of metal forming a ground shield 113. The uppermost layer of the multilevel interconnect 110 is a passivation layer 114. The distance between the ground shield 113 and the top of the passivation layer 114 may be as much as 9 µm when several metal layers are present.

The purpose of the ground shield 113 is to reduce the interaction between the electromagnetic fields generated by components above the shield and the substrate 100 below.

There are contact pads 115, such as bond pads, arranged on the upper metal level of the multilayer interconnect 110. The block of molding resin 11 is arranged enveloping the semiconductor die 10 so that the top surface of the multilayer interconnect 110 is left free and the top surface of the molding resin 11 is approximately flush with the top surface of multilayer interconnect 110.

Across the top of the multilayer interconnect 110 of the semiconductor die 10 and of the block of molding resin 11, is placed a redistribution structure 12.

The redistribution structure 12 is composed of a series of layers. There is a first dielectric layer 120 which lies on the surface formed by the passivation layer 114 of the semiconductor die 10 and the block of molding resin 11.

Through the first dielectric layer 120, pass conductive vias 121. The conductive vias 121 connect the contact pads 114 of the semiconductor die 10 to a metal layer 122 arranged above the dielectric layer 120. The metal layer 122 has formed in it solder pads 123 for connections to external circuitry (not shown) and windings 124 forming a planar inductor.

There is protection layer 125, made from a second dielectric layer, which covers the metal layer 122 except for openings over the solder pads 123.

In general, soldering is done on much larger features than those used on the semiconductor die so redistribution is used to connect the closely spaced bond pads 115 to the more widely spaced solder pads 123.

Onto the solder pads 123, optional solder balls 13 may be placed.

The first dielectric layer 120 is typically about 7 µm thick. The metal layer 122 is typically about 7 µm thick and the protection layer 124 is typically about 9 µm thick.

Fig 2 represents a plan view of the electronic component 1, viewed from the side of the solder balls 13. Of the elements described previously, only those requiring further detail will be further described. Metal tracks 126 may be used to connect the conductive vias 121 to the solder pads 123.

Advantageously, the windings of the planar inductor 124 are positioned vertically above the ground shield 113. The ground shield 113 reduces the influence of the substrate 100 of the semiconductor die 10 by limiting the degree to which the electromagnetic field from the planar inductor 124 penetrates the substrate100, thereby reducing the losses suffered by the planar inductor 124.

It may be advantageous if the area occupied by the windings 124 is contained within that occupied by the ground shield 113. However, surface area of the semiconductor die 10 is at a premium so it is not desirable to make the ground shield 113 any larger than necessary.

The metal layer 122 of the redistribution structure 12 is around twice the thickness of that of the thickest metal layer 111 of the multilevel interconnect 110. Therefore the series resistance of the windings of the planar inductor 124 is significantly reduced compared to that obtainable in windings formed in the thickest metal layer 111 of the semiconductor die 10. Thus a much improved quality factor is obtained.

The presence of the ground shield 113 allows the planar inductor 124 to be placed above the semiconductor die 10, rather than to one side. Thus the overall series resistance is reduced relative to the situation where the planar inductor 124 is offset.

Though the ground shield 113 is generally beneficial, it has certain effects on the characteristics of the planar inductor 124 which result in certain compromises being necessary.

The ground shield 113 is seen by the planar inductor 124 as a capacitive coupling both to ground. This capacitive coupling reduces the quality factor of the planar inductor 124. By increasing the distance between the ground shield 113 and the planar inductor 124, this effect may be reduced, thereby improving the quality factor. With distances above 10 µm, the degradation due to capacitive coupling becomes acceptable.

However the ground shield 113 has the effect of distorting the electromagnetic field of the planar inductor 124 in such a way that the electromagnetic field interacts less with other metal objects such as tracks on any PCB to which the electronic component 1 is connected. Therefore it is desirable to keep the ground shield 113 closer than these other metal objects. If the distance between the planar inductor 124 and the ground shield 113 is kept below 25 µm, the influence of the PCB can be neglected since it will be of the order of over 100 µm away.

It would be possible to form the ground shield 113 by adding an extra metal and dielectric layer to the redistribution structure 12. However this presents certain drawbacks.

Firstly, the additional layers increase the cost noticeably.

Secondly, the standard dielectric thickness is around 7 µm which, in certain cases, would place the planar inductor 124 closer to a ground shield made this way, as compared to a ground shield contained in the semiconductor dies 10. Thus the performance of the planar inductor 124 would be degraded.

The new dielectric layer would have to be much thicker, i.e. around 16 µm, in order to obtain the same distance between the ground shield 113 and the planar inductor 124 as that obtained with an embodiment. Such a thick dielectric layer would be even more expensive and would require wider vias thus making the routing density lower. Since many devices have large numbers of solder pad 123 and bond pads 114, the routing density is an important factor in determining overall package size.

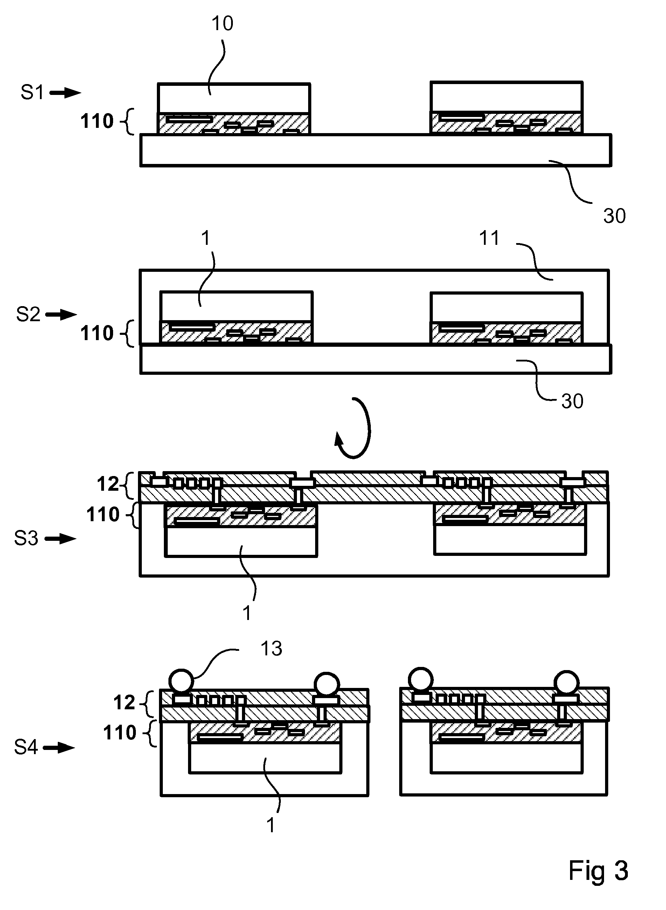

Figure 3 represents a simplified process for manufacturing an electronic component according to an embodiment.

At step S1, a number of semiconductor dice 10 are placed on a support 30, with the top surface of the multilevel interconnect 110 in contact with the support 30. The support is constructed so as to hold the semiconductor dice 10 in place. A sticky surface which allows the semiconductor dice 10 to be easily removed is a possible technique for this purpose.

At step S2, semiconductor dice 10 are enclosed in a block of molding resin 11 which covers in one block all the semiconductor dice 10. The block of molding resin 11 does not cover the top surfaces of the multilevel interconnect 110 of the semiconductor dice 10. The block of molding resin is hardened by curing.

At step S3, the support 30 is removed and a redistribution structure 12 is formed across the top surfaces of the multilevel interconnects 110 of the semiconductor dice 10. The redistribution structure 12 may be formed using thin-film techniques. With such techniques, it is possible to align accurately features in the redistribution structure 12 with features in the multilevel interconnect 110. Thus it is possible to ensure that the planar inductor 124 is correctly aligned with of the ground shield 113.

In the case where a PCB substrate has been used for the redistribution, instead of the thin-film techniques, the accuracy of alignment necessary for the planar inductor 124 and ground shield 113 is difficult to obtain.

At step S4, the individual electronic components 1 are separated and, where appropriate, solder balls 13 are attached to the solder pads 123. The order of these two steps may be varied according the details of the manufacturing process. Sawing may be used for separating the individual electronic components 1.

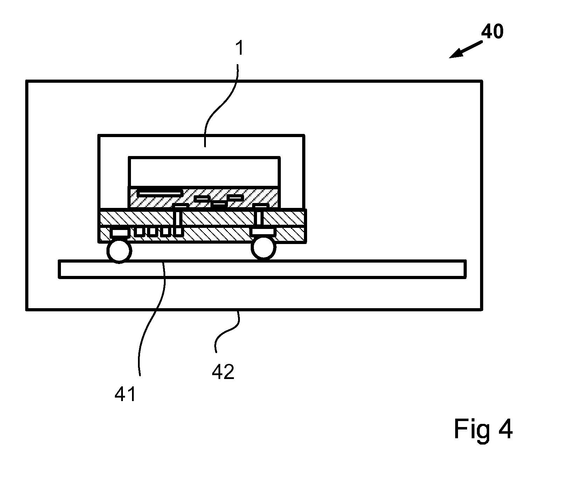

Figure 4 represents a cross-section view of a piece of electronic equipment 40 comprising an electronic component 1, according to an embodiment, attached to a PCB 41. The attachment method should provide for some of the connections to be conductive. For this some form of soldering may be used and this choice is within the scope of the skilled person. Around the outside of the piece of electronic equipment is a casing 42. Certain plastics may be suitable for this purpose and the skilled person will be able to choose.

The foregoing is given purely by way of example and is, in no way, intended to be limitative. Indeed, other variants are possible.

For example it may be possible to use techniques other than thin-film processing for making the redistribution structure 12, as long as the alignment tolerances needed between the planar inductor 124 and the ground shield 113 are respected.

For example the planar inductor 124 has been shown with only one tum. It is possible to leave an area near the centre of the ground shield 113 free. Through this area a connection to a conductive via 121 may be made which in tum can be connected to one end of the planar inductor 124. The planar inductor so formed may then have more turns.

For example is may be possible to have more than one planar inductor 124 above a single ground shield 113.

For example, it may be possible to use other conductive materials than metal in the redistribution structure.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. An electronic device (1) comprising:
- an electronic component (10) having a substrate and a plurality of metal interconnection layers (111), said plurality of metal interconnection layers having a top surface;
- a dielectric layer (120) situated above said metal interconnection layers (111);
- at least one conductive layer (122) situated above said dielectric layer;
- an inductor coil (124) and a ground shield (113),
wherein said inductor coil (124) is formed in said at least one conductive layer (122) and said ground shield (113) is formed a layer of said plurality of metal interconnection layers (111).

2. The electronic device of claim 1 wherein said inductor coil is vertically above said ground coil and the plane of said inductor coil is substantially parallel to the plane of said ground shield.

3. The electronic device of claims 1 or 2 wherein the shortest distance between said inductor coil and said ground shield is not less than 10 µm.

4. The electronic device of claims 1 to 3 wherein the shortest distance between said inductor coil and said ground shield is not greater than 25 µm.

5. The electronic device of one of claims 1 to 4 wherein the area occupied by said inductor coil is less than that occupied by said ground shield.

6. The electronic device of any of claims 1 to 5 wherein said electronic component is a semiconductor die.

7. The electronic device of any of claims 1 to 6 wherein said metal interconnection layers are arranged vertically above one another and said ground shield is formed in a metal interconnection layer close to said substrate.

8. The electronic device of any of claims 1 to 7 further comprising a block of molding resin (11) partially encapsulating said electronic component so that said top surface of said metal interconnection layers is left free.

9. The electronic device of claim 8 wherein the block of molding resin has a top surface flush with said top surface of said metal interconnection layers.

10. An electronic equipment (40) comprising an electronic device of any of claims 1 to 9.

11. A process of manufacturing the electronic device of any of claims 1 to 9 comprising the steps of:
- providing an electronic component having a plurality of metal interconnection layers in which is formed a ground shield;
- placing a dielectric layer above said multilevel interconnect;
- placing a conductive layer above said dielectric layer;
- forming a pattern in said conductive layer,
wherein the step of patterning the conductive layer forms an inductor coil which is vertically aligned to the ground shield.

12. The process of claim 11 wherein the dielectric layer and the conductive layer are made using thin-film techniques.

13. The process of either of claims 11 or 12 further comprising the step of partially encapsulating the electronic component in molding resin in a way that the top surface of the multilevel interconnect is left free.

14. The process of any of claims 11 to 13 further comprising the step of forming a protection layer partially covering said conductive and dielectric layers.
